# EUROPEAN PATENT SPECIFICATION

(11) **EP 4 044 212 B1**
(45) Date of publication and mention of the grant of the patent: **14.02.2024**
(21) Application number: 19952859.7
(22) Date of filing: 14.11.2019
(51) Int. Cl.: H01L 21/02, C30B 29/36

(54) **SEMICONDUCTOR SUBSTRATE, MANUFACTURING METHOD THEREFOR, AND SEMICONDUCTOR DEVICE**
HALBLEITERSUBSTRAT, HERSTELLUNGSVERFAHREN DAFÜR UND HALBLEITERBAUELEMENT
SUBSTRAT SEMI-CONDUCTEUR, SON PROCÉDÉ DE FABRICATION, ET DISPOSITIF SEMI-CONDUCTEUR

(43) Date of publication of application: 17.08.2022
(73) Proprietor: Huawei Digital Power Technologies Co., Ltd., Shenzhen, Guangdong 518043 (CN)
(72) Inventor: HUANG, Boning, Shenzhen, Guangdong 518129 (CN); WAN, Yuxi, Shenzhen, Guangdong 518129 (CN); WANG, Yiyu, Shenzhen, Guangdong 518129 (CN)
(74) Representative: MERH-IP Matias Erny Reichl Hoffmann Patentanwälte PartG mbB
(86) International application number: PCT/CN2019/118562
(87) International publication number: WO 2021/092862

(56) References cited:
- EP-A1- 2 432 000
- EP-A1- 3 489 990
- CN-A- 102 422 387
- CN-A- 102 422 387
- CN-A- 105 702 712
- JP-A- 2011 243 770
- JP-A- 2014 057 035
- US-A1- 2011 284 871
- US-A1- 2011 284 872
- US-A1- 2012 012 862
- US-A1- 2012 181 550
- US-A1- 2013 056 752

## Description

### TECHNICAL FIELD

This application relates to the field of semiconductor technologies, and in particular, to a semiconductor substrate, a production method thereof, and a semiconductor device.

### BACKGROUND

Currently, when a semiconductor device is produced, epitaxy and production of a semiconductor chip are usually performed on a semiconductor substrate, and a hexagonal silicon carbide whose stacking periodicity is 4 (4H-SiC) layer is disposed on a surface of the semiconductor substrate. The 4H-SiC layer is a material layer obtained by cutting a 4H-SiC wafer. 4H-SiC is an allotrope of SiC, and has a hexagonal lattice structure. In addition, because the semiconductor device has a relatively high quality requirement on the 4H-SiC, an actually produced 4H-SiC wafer can hardly meet the quality requirement, in other words, a yield of the 4H-SiC wafer is relatively low, resulting in relatively high costs of the 4H-SiC wafer. A 4H-SiC wafer that meets the wafer quality requirement is usually referred to as a 4H-SiC crystal wafer (4H-SiC crystal wafer), and 4H-SiC in the 4H-SiC crystal wafer may be referred to as high-quality 4H-SiC.

Because the high-quality 4H-SiC is relatively costly, to reduce costs of the semiconductor substrate, the semiconductor substrate usually includes a base and a 4H-SiC layer disposed on a surface of the base. A material of the 4H-SiC layer is high-quality 4H-SiC. The 4H-SiC layer is disposed on the substrate, so that it can be ensured that a surface of the semiconductor substrate is covered with high-quality 4H-SiC. In addition, the base provides a support for the 4H-SiC layer, to ensure relatively large hardness of the semiconductor substrate, so that use of the high-quality 4H-SiC is reduced, thereby reducing costs of the semiconductor substrate.

However, because a material of the base is different from the material of the 4H-SiC layer, lattice coefficients of the base and the 4H-SiC layer do not match. After the 4H-SiC layer is bound to the base, a heterojunction occurs on a binding surface between the 4H-SiC layer and the base, resulting in a relatively poor ohmic contact characteristic of the binding surface and poor conductive performance between the base and the 4H-SiC layer. Therefore, how to improve the ohmic characteristic of the semiconductor substrate while controlling costs of the semiconductor substrate to be relatively low is a problem that urgently needs to be resolved. In a related technology, before the 4H-SiC layer is bound to the base, pretreatment may be performed on a surface that is of the base and that is used for binding and a surface that is of the 4H-SiC layer and that is used for binding. For example, N-type doping is performed on both the surface that is of the base and that is used for binding and the surface that is of the 4H-SiC layer and that is used for binding, to improve the ohmic contact characteristic of the binding surface while controlling costs of the semiconductor substrate to be relatively low. However, a production process of the semiconductor substrate is complex.

JP 2011 243770 A discloses a silicon carbide substrate including a SiC layer made of single crystal silicon carbide having a lower concentration of unavoidable impurities than that of a base layer, wherein the SiC layer is disposed on a main surface of the base layer that is made of silicon carbide.

US 2012/012862 A1 describes a method for manufacturing a silicon carbide substrate that includes the steps of: preparing a base substrate made of silicon carbide and a SiC substrate made of single-crystal silicon carbide; and connecting the base substrate and SiC substrate to each other by forming an intermediate layer, which is made of carbon that is a conductor, between the base substrate and the SiC substrate.

In EP 2 432 000 A1, a silicon carbide substrate includes a base substrate composed of silicon carbide and an SiC layer composed of single crystal silicon carbide different from the base substrate and arranged on the base substrate in contact therewith.

US 2012/181550 A1 discloses that a compound semiconductor substrate includes a first substrate and a second substrate made of single crystal silicon carbide. In each of the first substrate and the second substrate, one surface is a (000-1) C-face and an opposite surface is a (0001) Si-face. The first substrate and the second substrate are bonded to each other in a state where the (0001) Si-face of the first substrate and the (0001) Si-face of the second substrate face each other, and the (000-1) C-face of the first substrate and the (000-1) C-face of the second substrate are exposed.

EP 3 489 990 A1 discloses a bonded semiconductor substrate which comprises a single-crystalline SiC substrate and a polycrystalline SiC substrate. Further, a particular atom introducing step is performed, wherein particular atoms may be any atoms so long as they can alter a crystal structure of the single-crystalline substrate.

### SUMMARY

This application provides a semiconductor substrate, a production method thereof, and a semiconductor device, to resolve a problem that a production process of a semiconductor substrate is complex when costs of the semiconductor substrate need to be controlled and an ohmic contact characteristic of a binding surface needs to be improved. Embodiments of the present invention are defined by the independent claims. Additional features of embodiments of the invention are presented in the dependent claims. In the following, parts of the description and drawings referring to former embodiments which do not necessarily comprise all features to implement embodiments of the claimed invention are not represented as embodiments of the invention but as examples useful for understanding the embodiments of the invention.

According to a first aspect, this application provides a semiconductor substrate. The semiconductor substrate includes a monocrystalline silicon carbide base and a monocrystalline silicon carbide layer stacked on a side of the monocrystalline silicon carbide base. A quality indicator of the monocrystalline silicon carbide base is lower than a quality indicator of the monocrystalline silicon carbide layer.

In the semiconductor substrate provided in this embodiment of this application, because materials of both the monocrystalline silicon carbide base and the monocrystalline silicon carbide layer are monocrystalline silicon carbide, a material difference between the monocrystalline silicon carbide base and the monocrystalline silicon carbide layer is reduced, and a probability that a heterojunction occurs on a binding surface is reduced. Therefore, while controlling costs of the semiconductor substrate to be relatively low, using the monocrystalline silicon carbide base with a relatively low quality indicator can ensure an ohmic contact characteristic between the monocrystalline silicon carbide base and the monocrystalline silicon carbide layer without a need to perform additional processing on the binding surface in a production process, to simplify the production process of the semiconductor substrate.

In a feasible manner, a crystal structure of the monocrystalline silicon carbide base is the same as that of the monocrystalline silicon carbide layer. When the crystal structure of the monocrystalline silicon carbide base is the same as that of the monocrystalline silicon carbide layer, the probability that a heterojunction occurs on the binding surface can be further reduced, and even the heterojunction can be avoided at the binding surface. Therefore, the ohmic contact characteristic of the semiconductor substrate can be further ensured.

For example, both a material of the monocrystalline silicon carbide base and a material of the monocrystalline silicon carbide layer are 4H-SiC. When both the material of the monocrystalline silicon carbide base and the material of the monocrystalline silicon carbide layer are 4H-SiC, the ohmic contact characteristic between the monocrystalline silicon carbide base and the monocrystalline silicon carbide layer can be effectively ensured.

Electrons are doped on one or two of a side that is of the monocrystalline silicon carbide base and that is close to the monocrystalline silicon carbide layer and a side that is of the monocrystalline silicon carbide layer and that is close to the monocrystalline silicon carbide base. Free electrons are formed in the doped monocrystalline silicon carbide layer and the doped monocrystalline silicon carbide base, and the free electrons can improve conductive performance of the material, so that the ohmic contact characteristic between the monocrystalline silicon carbide base and the monocrystalline silicon carbide layer is improved.

The quality indicator is reflected by one or more of the following: micropipe density, dislocation fault density, stacking fault density, a proportion of polytype areas, and a proportion of carbon inclusions areas.

According to a second aspect, this application provides a production method for a semiconductor substrate. The method includes: providing a monocrystalline silicon carbide base and a monocrystalline silicon carbide wafer, where a quality indicator of the monocrystalline silicon carbide base is lower than a quality indicator of the monocrystalline silicon carbide wafer; performing N-type doping on a surface that is of the monocrystalline silicon carbide base and that is used for binding and a surface that is of the monocrystalline silicon carbide wafer and that is used for binding; binding the monocrystalline silicon carbide wafer to the monocrystalline silicon carbide base; and peeling off a monocrystalline silicon carbide layer of a specified thickness from a side that is of the monocrystalline silicon carbide wafer and that is away from the monocrystalline silicon carbide base, to obtain the semiconductor substrate, where the specified thickness is less than a thickness of the monocrystalline silicon carbide wafer, and a direction of the thickness is perpendicular to a direction in which a binding surface between the monocrystalline silicon carbide wafer and the monocrystalline silicon carbide base is located.

Before the binding the monocrystalline silicon carbide wafer to the monocrystalline silicon carbide base, the method further includes: separately performing surface pretreatment on a surface that is of the monocrystalline silicon carbide base and that is used for binding and a surface that is of the monocrystalline silicon carbide wafer and that is used for binding, to improve an ohmic contact characteristic between the monocrystalline silicon carbide base and the monocrystalline silicon carbide wafer that are bound. Correspondingly, the implementation process of binding the monocrystalline silicon carbide wafer to the monocrystalline silicon carbide base includes: binding, to the surface that is of the monocrystalline silicon carbide base and that is obtained through surface pretreatment, the surface that is of the monocrystalline silicon carbide wafer and that is obtained through surface pretreatment.

In a feasible manner, the separately performing surface pretreatment on the monocrystalline silicon carbide base and the monocrystalline silicon carbide wafer includes: separately performing plasma bombardment processing on the surface that is of the monocrystalline silicon carbide base and that is used for binding and the surface that is of the monocrystalline silicon carbide wafer and that is used for binding. Performing plasma bombardment processing can remove substances such as an oxide layer and dirt on the surface that is of the monocrystalline silicon carbide base and that is used for binding and the surface that is of the monocrystalline silicon carbide wafer and that is used for binding, so that an effect of blinding the monocrystalline silicon carbide base and the monocrystalline silicon carbide wafer can be improved, thereby improving the ohmic contact characteristic of the binding surface.

After the separately performing plasma bombardment processing on the surface that is of the monocrystalline silicon carbide base and that is used for binding and the surface that is of the monocrystalline silicon carbide wafer and that is used for binding, the implementation process of separately performing surface pretreatment on a surface that is of the monocrystalline silicon carbide base and that is used for binding and a surface that is of the monocrystalline silicon carbide wafer and that is used for binding further includes: performing N-type doping on one or two of the surface that is of the monocrystalline silicon carbide base and that is used for binding and the surface that is of the monocrystalline silicon carbide wafer and that is used for binding. Free electrons are formed in the doped monocrystalline silicon carbide layer and the doped monocrystalline silicon carbide base, and the free electrons can improve conductive performance of a material, so that the ohmic contact characteristic between the monocrystalline silicon carbide base and the monocrystalline silicon carbide layer is improved.

In a feasible manner, before the peeling off a monocrystalline silicon carbide layer of a specified thickness from a side that is of the monocrystalline silicon carbide wafer and that is away from the monocrystalline silicon carbide base, to obtain the semiconductor substrate, the method further includes: performing ion implantation processing on the monocrystalline silicon carbide wafer from a side, of the monocrystalline silicon carbide wafer, away from the surface that is of the monocrystalline silicon carbide wafer and that is used for binding, to form an ion implantation layer in the monocrystalline silicon carbide wafer. Correspondingly, the implementation process of peeling off a monocrystalline silicon carbide layer of a specified thickness from a side that is of the monocrystalline silicon carbide wafer and that is away from the monocrystalline silicon carbide base, to obtain the semiconductor substrate includes: performing layering processing on the monocrystalline silicon carbide wafer in which the ion implantation layer is formed, so that the monocrystalline silicon carbide wafer is layered at the ion implantation layer; and performing a peeling operation on the layered monocrystalline silicon carbide wafer from the ion implantation layer to obtain the semiconductor substrate.

According to an embodiment not being part of the present invention, the semiconductor substrate includes a graphite base and a monocrystalline silicon carbide layer stacked on a side of the graphite base. Electrons are doped on one or two of a side that is of the graphite base and that is close to the monocrystalline silicon carbide layer and a side that is of the monocrystalline silicon carbide layer and that is close to the graphite base.

Because graphite has relatively good heat conduction and heat dissipation performance, when a material of the graphite base is graphite, a semiconductor device formed on the semiconductor substrate has relatively good heat dissipation performance, so that impact on performance of the semiconductor device that is caused by thermal interference can be reduced.

In this example not part of the invention, a quality indicator of the graphite base is lower than a quality indicator of the monocrystalline silicon carbide layer. The quality indicator is reflected by one or more of the following: flatness, a resistivity, surface roughness, and a thickness.

Because the quality indicator of the graphite base is lower than the quality indicator of the monocrystalline silicon carbide layer, costs of the graphite base are relatively low, so that costs of the semiconductor substrate can be greatly reduced.

According to another aspect not part of the present invention, an example provides a production method for a semiconductor substrate. The method includes: providing a graphite base and a monocrystalline silicon carbide wafer; performing N-type doping on one or two of a surface that is of the graphite base and that is used for binding and a surface that is of the monocrystalline silicon carbide wafer and that is used for binding; binding the monocrystalline silicon carbide wafer to the graphite base; and peeling off a monocrystalline silicon carbide layer of a specified thickness from a side that is of the monocrystalline silicon carbide wafer and that is away from the graphite base, to obtain the semiconductor substrate. The specified thickness is less than a thickness of the monocrystalline silicon carbide wafer, and a direction of the thickness is perpendicular to a direction in which a binding surface between the monocrystalline silicon carbide wafer and the graphite base is located.

In this example not part of the invention, a quality indicator of the graphite base is lower than a quality indicator of the monocrystalline silicon carbide wafer.

In a feasible manner, before the binding the monocrystalline silicon carbide wafer to the graphite base, the method not part of the present invention further includes: separately performing surface pretreatment on the surface that is of the graphite base and that is used for binding and the surface that is of the monocrystalline silicon carbide wafer and that is used for binding, to improve an ohmic contact characteristic between the graphite base and the monocrystalline silicon carbide wafer that are bound. Correspondingly, the implementation process of binding the monocrystalline silicon carbide wafer to the graphite base includes: binding, to the surface that is of the graphite base and that is obtained through surface pretreatment, the surface that is of the monocrystalline silicon carbide wafer and that is obtained through surface pretreatment.

The implementation process of separately performing surface pretreatment on the graphite substrate and the monocrystalline silicon carbide wafer includes: separately performing plasma bombardment processing on the surface that is of the graphite base and that is used for binding and the surface that is of the monocrystalline silicon carbide wafer and that is used for binding.

In a feasible manner, before the peeling off a monocrystalline silicon carbide layer of a specified thickness from a side that is of the monocrystalline silicon carbide wafer and that is away from the graphite base, to obtain the semiconductor substrate, the method further includes: performing ion implantation processing on the monocrystalline silicon carbide wafer from a side, of the monocrystalline silicon carbide wafer, away from the surface that is of the monocrystalline silicon carbide wafer and that is used for binding, to form an ion implantation layer in the monocrystalline silicon carbide wafer. Correspondingly, the implementation process of peeling off a monocrystalline silicon carbide layer of a specified thickness from a side that is of the monocrystalline silicon carbide wafer and that is away from the graphite base, to obtain the semiconductor substrate includes: performing layering processing on the monocrystalline silicon carbide wafer in which the ion implantation layer is formed, so that the monocrystalline silicon carbide wafer is layered at the ion implantation layer; and performing a peeling operation on the layered monocrystalline silicon carbide wafer from the ion implantation layer to obtain the semiconductor substrate.

According to a fifth aspect, this application provides a semiconductor device, including the semiconductor substrate provided in the first aspect or the third aspect and at least one semiconductor film layer disposed on the semiconductor substrate.

### BRIEF DESCRIPTION OF DRAWINGS

FIG. 1 is a schematic diagram of a structure of a semiconductor substrate according to an embodiment of this application;
FIG. 2 is a flowchart of a production method for a semiconductor substrate according to an embodiment of this application;
FIG. 3 is a schematic diagram of performing plasma bombardment processing on a surface that is of a monocrystalline silicon carbide base and that is used for binding and a surface that is of a monocrystalline silicon carbide wafer and that is used for binding according to an embodiment of this application;
FIG. 4 is a schematic diagram in which a monocrystalline silicon carbide wafer and a monocrystalline silicon carbide base are bound according to an embodiment of this application;
FIG. 5 is a schematic diagram of performing ion implantation on a monocrystalline silicon carbide wafer according to an embodiment of this application; and
FIG. 6 is a schematic diagram of a monocrystalline silicon carbide wafer obtained after high-temperature annealing processing according to an embodiment of this application.

### DESCRIPTION OF EMBODIMENTS

To make objectives, technical solutions, and advantages of this application clearer, the following further describes implementations of this application in detail with reference to accompanying drawings.

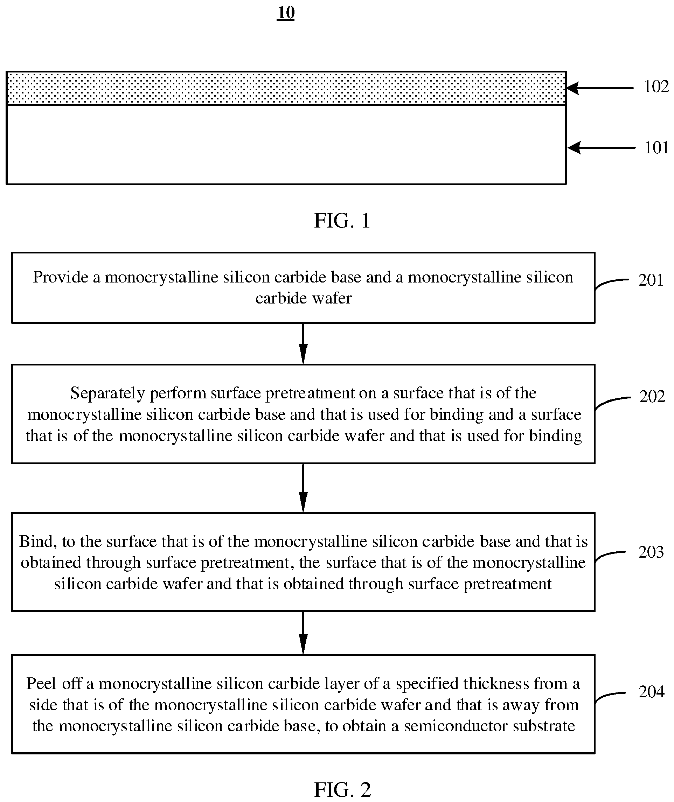

An embodiment of this application provides a semiconductor substrate. As shown in FIG. 1, the semiconductor substrate 10 includes a monocrystalline silicon carbide base 101 and a monocrystalline silicon carbide layer 102 stacked on a side of the monocrystalline silicon carbide base 101. A quality indicator of the monocrystalline silicon carbide base 101 is lower than a quality indicator of the monocrystalline silicon carbide layer 102. The quality indicator is an indicator reflecting a quality requirement. For example, the quality indicator of the monocrystalline silicon carbide base 101 may be a design specification (specification) of the monocrystalline silicon carbide base 101, and the quality indicator of the monocrystalline silicon carbide layer 102 may be a design specification of the monocrystalline silicon carbide layer 102. Correspondingly, that a quality indicator of the monocrystalline silicon carbide base 101 is lower than a quality indicator of the monocrystalline silicon carbide layer 102 means that a quality requirement of the monocrystalline silicon carbide base 101 is lower than a quality requirement of the monocrystalline silicon carbide layer 102.

Materials of both the monocrystalline silicon carbide base 101 and the monocrystalline silicon carbide layer 102 are silicon carbide, and a quality indicator of the silicon carbide may be reflected by one or more of the following parameters: micropipe density (micropipe density), dislocation fault density (dislocation fault density), stacking fault density (stacking fault density), a proportion of polytype areas (polytype areas), and a proportion of carbon inclusions areas (carbon inclusions areas).

A micropipe is a hollow pipe that extends in a specified direction and whose radial size ranges from one micron to dozens of microns in monocrystalline silicon carbide whose stacking periodicity is 4 or 6. A dislocation is a linear defect of partial irregular arrangement of atoms in a crystalline material. The dislocation fault density may be total fault density of one or more of a threading edge dislocation (threading edge dislocation, TED), a threading screw dislocation (threading screw dislocation, TSD), and a basal plane dislocation (basal, BPD). A stacking fault is a misalignment defect that atoms in a crystalline material are not arranged in an atom arrangement sequence determined by a growth direction. "Polytype" means that another crystalline form is included in silicon carbide. For example, cubic silicon carbide whose stacking periodicity is 3 (3C-SiC), hexagonal silicon carbide whose stacking periodicity is 6 (6H-SiC), hexagonal silicon carbide whose stacking periodicity is 8 (8H-SiC), and rhombohedral silicon carbide whose stacking periodicity is 15 (15R-SiC) are included in the silicon carbide. The carbon inclusions area indicates that an atomic cluster or a small particle including carbon elements exists in 4H-SiC.

For example, the materials of both the monocrystalline silicon carbide base 101 and the monocrystalline silicon carbide layer 102 are monocrystalline silicon carbide. When a quality indicator of the monocrystalline silicon carbide is reflected by micropipe density, dislocation fault density, stacking fault density, a proportion of polytype areas, and a proportion of carbon inclusions areas, because quality of the monocrystalline silicon carbide is negatively correlated with the micropipe density, the dislocation fault density, the stacking fault density, the proportion of polytype areas, and the proportion of carbon inclusions areas, that a quality indicator of the monocrystalline silicon carbide base 101 is lower than a quality indicator of the monocrystalline silicon carbide layer 102 may mean that a parameter reflecting the quality indicator meets one or more of the following parameter conditions: Micropipe density of the monocrystalline silicon carbide base 101 is greater than micropipe density of the monocrystalline silicon carbide layer 102, dislocation fault density of the monocrystalline silicon carbide base 101 is greater than dislocation fault density of the monocrystalline silicon carbide layer 102, stacking fault density of the monocrystalline silicon carbide base 101 is greater than stacking fault density of the monocrystalline silicon carbide layer 102, a proportion of polytype areas of the monocrystalline silicon carbide base 101 is greater than a proportion of polytype areas of the monocrystalline silicon carbide layer 102, and a proportion of carbon inclusions areas of the monocrystalline silicon carbide base 101 is greater than a proportion of carbon inclusions areas of the monocrystalline silicon carbide layer 102.

It should be noted that because a correlation between the plurality of parameters reflecting the quality indicator is relatively low, parameter conditions that are in the plurality of parameter conditions and that the parameter reflecting the quality indicator needs to meet may be determined as actually required. This is not specifically limited in this embodiment of this application. In a feasible manner, the parameter conditions that are in the plurality of parameter conditions and that the parameter reflecting the quality indicator needs to meet may be determined based on a cost budget of the semiconductor substrate. For example, when the parameter reflecting the quality indicator meets one of the plurality of parameter conditions, if costs of the semiconductor substrate do not exceed the cost budget, a monocrystalline silicon carbide base 101 and a monocrystalline silicon carbide layer 102 that meet the parameter condition can be used. In another feasible manner, the parameter conditions that are in the plurality of parameter conditions and that the parameter reflecting the quality indicator needs to meet may be determined based on a quality requirement of the semiconductor substrate. For example, when a micropipe quality requirement of the monocrystalline silicon carbide base 101 is stricter, and a micropipe quality requirement of the monocrystalline silicon carbide layer 102 is looser, the micropipe density of the monocrystalline silicon carbide base 101 may be equal to or even less than the micropipe density of the monocrystalline silicon carbide layer 102, and another parameter meets a corresponding parameter condition.

In the semiconductor substrate, because the materials of both the monocrystalline silicon carbide base 101 and the monocrystalline silicon carbide layer 102 are monocrystalline silicon carbide, a material difference between the monocrystalline silicon carbide base 101 and the monocrystalline silicon carbide layer 102 is reduced, and a probability that a heterojunction occurs on a binding surface is reduced. Therefore, while controlling costs of the semiconductor substrate to be relatively low, using the monocrystalline silicon carbide base with a relatively low quality indicator can ensure an ohmic contact characteristic between the monocrystalline silicon carbide base 101 and the monocrystalline silicon carbide layer 102 without a need to perform additional processing on the binding surface in a production process, to simplify the production process of the semiconductor substrate.

In a feasible manner, the monocrystalline silicon carbide base 101 and the monocrystalline silicon carbide layer 102 may be materials with a same crystal structure. When a crystal structure of the monocrystalline silicon carbide base 101 is the same as that of the monocrystalline silicon carbide layer 102, the probability that a heterojunction occurs on the binding surface can be further reduced, and even the heterojunction can be avoided at the binding surface. Therefore, the ohmic contact characteristic of the semiconductor substrate can be further ensured.

For example, both a material of the monocrystalline silicon carbide base 101 and a material of the monocrystalline silicon carbide layer 102 may be 4H-SiC. To be specific, the material of the monocrystalline silicon carbide layer 102 is high-quality 4H-SiC, and the material of the monocrystalline silicon carbide base 101 is low-quality 4H-SiC. The low-quality 4H-SiC is low-quality 4H-SiC with a reduced quality indicator. A 4H-SiC wafer made of the low-quality 4H-SiC is referred to as a 4H-SiC dummy wafer (4H-SiC dummy wafer). Because the 4H-SiC is a material with a high degree of doping, when both the material of the monocrystalline silicon carbide base 101 and the material of the monocrystalline silicon carbide layer 102 are 4H-SiC, the ohmic contact characteristic between the monocrystalline silicon carbide base 101 and the monocrystalline silicon carbide layer 102 can be effectively ensured.

When a quality indicator of the 4H-SiC is described by using micropipe density, dislocation fault density, stacking fault density, a proportion of polytype areas, and a proportion of carbon inclusions areas, a quality indicator of the high-quality 4H-SiC may be as follows: micropipe density ≤ 1 per square centimeter (cm⁻²), dislocation fault density ≤ 10000 cm⁻², stacking fault density ≤ 1000 cm⁻², proportion of polytype areas ≤ 0%, and proportion of carbon inclusions areas ≤ 1%, and a quality indicator of the low-quality 4H-SiC may be as follows: micropipe density ≤ 100 cm⁻², dislocation fault density ≤ 1000000 cm⁻², stacking fault density ≤ 100000 cm⁻², proportion of polytype areas ≤ 100%, and proportion of carbon inclusions areas ≤ 100%. It can be learned that a quality requirement of the low-quality 4H-SiC is much lower than a quality requirement of the high-quality 4H-SiC.

Because the quality indicator of the low-quality 4H-SiC is relatively low, a yield of the low-quality 4H-SiC is greatly improved, and costs of the low-quality 4H-SiC are greatly reduced. Therefore, when a base made of the low-quality 4H-SiC is used, costs of the semiconductor substrate can be effectively reduced.

Further, electrons may be doped on a side that is of the monocrystalline silicon carbide base 101 and that is close to the monocrystalline silicon carbide layer 102; or electrons may be doped on a side that is of the monocrystalline silicon carbide layer 102 and that is close to the monocrystalline silicon carbide base 101; or electrons may be doped on both a side that is of the monocrystalline silicon carbide base 101 and that is close to the monocrystalline silicon carbide layer 102 and a side that is of the monocrystalline silicon carbide layer 102 and that is close to the monocrystalline silicon carbide base 101. The doped electrons are obtained through an N-type doping process. In addition, during N-type doping, a dopant may be nitrogen atoms or phosphorus atoms, and a dose of the dopant may be e¹³ cm⁻² to e¹⁶ cm⁻²,

After the doping is completed, free electrons are formed in the doped monocrystalline silicon carbide layer 102 and the doped monocrystalline silicon carbide base 101, and the free electrons can improve conductive performance of the material, so that the ohmic contact characteristic between the monocrystalline silicon carbide base 101 and the monocrystalline silicon carbide layer 102 is improved. In addition, both the monocrystalline silicon carbide base 101 and the monocrystalline silicon carbide layer 102 are monocrystalline substances, in other words, there is no polycrystalline grain boundary in the monocrystalline silicon carbide base 101 and the monocrystalline silicon carbide layer 102. In comparison with a base including a polycrystalline substance, during N-type doping, uniformity of N-type doping can be ensured, so that conductive performance between the base and the 4H-SiC layer can be effectively improved.

It should be noted that in the semiconductor substrate provided in further examples not being part of the present invention, the material of the base may be alternatively graphite. Because graphite has relatively good heat conduction and heat dissipation performance, when a material of the graphite base is graphite, a semiconductor device formed on the semiconductor substrate has relatively good heat dissipation performance, so that impact on performance of the semiconductor device that is caused by thermal interference can be reduced.

In addition, when the material of the base is graphite, because the graphite and the monocrystalline silicon carbide layer 102 are different materials, electrons may also be doped on a side that is of the base made of the graphite and that is close to the monocrystalline silicon carbide layer 102 and a side that is of the monocrystalline silicon carbide layer 102 and that is close to the base, so that the ohmic contact characteristic between the base and the 4H-SiC layer can be effectively ensured. For an implementation of doping electrons into the graphite, correspondingly refer to the implementation of doping electrons into the monocrystalline silicon carbide base and the monocrystalline silicon carbide layer. Details are not described herein again.

A quality indicator of the graphite base is lower than the quality indicator of the monocrystalline silicon carbide layer. Optionally, the quality indicator of the graphite base may be reflected by one or more of the following: flatness, a resistivity, surface roughness, and a thickness. Because costs of the graphite base are relatively low, costs of the semiconductor substrate can be greatly reduced.

In conclusion, in the semiconductor substrate provided in this embodiment of this application, because the materials of both the monocrystalline silicon carbide base and the monocrystalline silicon carbide layer are monocrystalline silicon carbide, the material difference between the monocrystalline silicon carbide base and the monocrystalline silicon carbide layer is reduced, and the probability that a heterojunction occurs on the binding surface is reduced. Therefore, while controlling costs of the semiconductor substrate to be relatively low, using the monocrystalline silicon carbide base with a relatively low quality indicator can ensure the ohmic contact characteristic between the monocrystalline silicon carbide base and the monocrystalline silicon carbide layer without a need to perform additional processing on the binding surface in the production process, to simplify the production process of the semiconductor substrate.

In addition, because the semiconductor substrate includes the monocrystalline silicon carbide base, in comparison with a related technology in which a produced 4H-SiC epitaxial layer needs to be sufficiently thick because a semiconductor substrate does not include a base, in the semiconductor substrate, thicknesses of the monocrystalline silicon carbide layer and the 4H-SiC epitaxial layer can be determined based on a voltage level of the semiconductor device. Therefore, the semiconductor substrate can be applied to producing semiconductor devices of all voltage levels, so that an application scope of the semiconductor substrate is expanded.

An embodiment of this application further provides a production method for a semiconductor substrate. As shown in FIG. 2, the method may include the following steps.

Step 201: Provide a monocrystalline silicon carbide base and a monocrystalline silicon carbide wafer.

A quality indicator of the monocrystalline silicon carbide base is lower than a quality indicator of the monocrystalline silicon carbide wafer. Optionally, a quality indicator of silicon carbide may be reflected by one or more of the following parameters: micropipe density, dislocation fault density, stacking fault density, a proportion of polytype areas, and a proportion of carbon inclusions areas.

In a feasible manner, the monocrystalline silicon carbide base and the monocrystalline silicon carbide wafer may be materials with a same crystal structure. For example, both a material of the monocrystalline silicon carbide base and a material of the monocrystalline silicon carbide wafer may be 4H-SiC. When a quality indicator of the 4H-SiC is described by using micropipe density, dislocation fault density, stacking fault density, a proportion of polytype areas, and a proportion of carbon inclusions areas, a quality indicator of high-quality 4H-SiC may be as follows: micropipe density ≤ 1 cm⁻², dislocation fault density ≤ 10000 cm⁻², stacking fault density ≤ 1000 cm⁻², proportion of polytype areas ≤ 0%, and proportion of carbon inclusions areas ≤ 1%, and a quality indicator of low-quality 4H-SiC may be as follows: micropipe density ≤ 100 cm⁻², dislocation fault density ≤ 1000000 cm⁻², stacking fault density ≤ 100000 cm⁻², proportion of polytype areas ≤ 100%, and proportion of carbon inclusions areas ≤ 100%. It can be learned that a quality requirement of the low-quality 4H-SiC is much lower than a quality requirement of the high-quality 4H-SiC.

In addition, parameters such as sizes, thicknesses, resistivities, and roughness of the monocrystalline silicon carbide base and the monocrystalline silicon carbide wafer may be determined based on an application requirement. For example, the sizes of the monocrystalline silicon carbide base and the monocrystalline silicon carbide wafer may be determined based on a size of a semiconductor device that needs to be produced. A thickness of the monocrystalline silicon carbide base may be determined based on a voltage level of the semiconductor device that needs to be produced. A thickness of the monocrystalline silicon carbide wafer is usually a thickness of a finished monocrystalline silicon carbide wafer, or is a thickness of a cut monocrystalline silicon carbide wafer. The resistivities of the monocrystalline silicon carbide base and the monocrystalline silicon carbide wafer may be determined based on a conductivity of the semiconductor device that needs to be produced. The roughness of the monocrystalline silicon carbide base and the monocrystalline silicon carbide wafer may be determined based on a binding quality requirement. It should be noted that if roughness of a monocrystalline silicon carbide base and a monocrystalline silicon carbide wafer that are provided does not meet an application requirement, surfaces of the monocrystalline silicon carbide base and the monocrystalline silicon carbide wafer may be polished by using a method such as chemical mechanical polishing (chemical mechanical polishing, CMP) until the roughness meets the application requirement.

For example, a wafer diameter of the monocrystalline silicon carbide wafer may be 4 inches, 6 inches, 8 inches, or 12 inches. The wafer thickness of the monocrystalline silicon carbide wafer may range from 50 µm to 1000 µm. A resistivity of the monocrystalline silicon carbide wafer may range from 0.010 ohm centimeter (Ω·cm) to 0.030 Ω·cm. Surface roughness of the monocrystalline silicon carbide wafer may be less than or equal to 2 nanometers (nm). A wafer diameter of the monocrystalline silicon carbide base may be 4 inches, 6 inches, 8 inches, or 12 inches. The wafer thickness of the monocrystalline silicon carbide base may range from 50 µm to 1000 µm. A resistivity of the monocrystalline silicon carbide base may range from 0.010 Ω·cm to 0.030 Ω·cm. Surface roughness of the monocrystalline silicon carbide base may be less than or equal to 2 nm.

It should be noted that the monocrystalline silicon carbide base may be alternatively a base made of graphite. In addition, parameters such as a size, a thickness, a resistivity, and roughness of the graphite substrate made of graphite may also be determined as actually required.

Step 202: Separately perform surface pretreatment on a surface that is of the monocrystalline silicon carbide base and that is used for binding and a surface that is of the monocrystalline silicon carbide wafer and that is used for binding, to improve an ohmic contact characteristic between the monocrystalline silicon carbide base and the monocrystalline silicon carbide wafer that are bound.

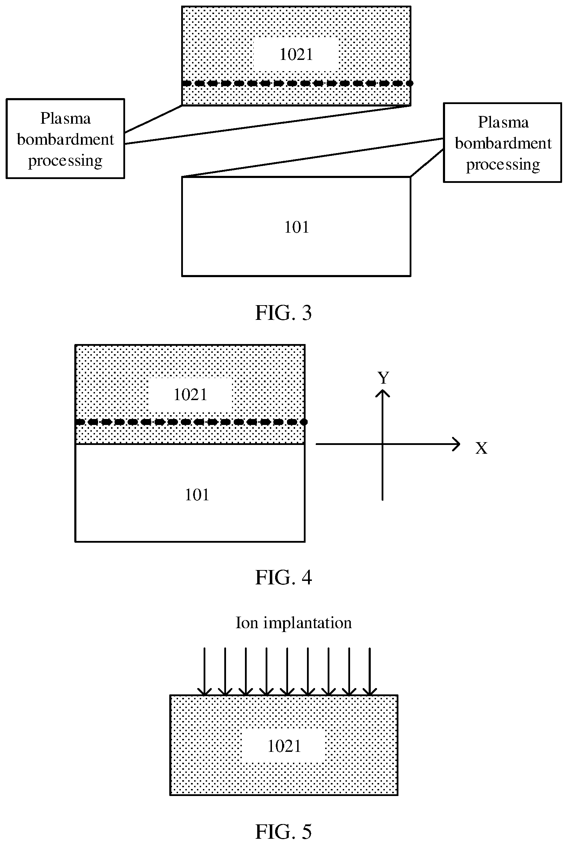

Dry processing or wet processing may be separately performed on the surface that is of the monocrystalline silicon carbide base and that is used for binding and the surface that is of the monocrystalline silicon carbide wafer and that is used for binding, to remove substances such as an oxide layer and dirt on the surface that is of the monocrystalline silicon carbide base and that is used for binding and the surface that is of the monocrystalline silicon carbide wafer and that is used for binding, so that an effect of blinding the monocrystalline silicon carbide base and the monocrystalline silicon carbide wafer is improved, thereby improving the ohmic contact characteristic of a binding surface. For example, the wet processing may be soaking, in hydrogen peroxide or ammonia, the surface that is of the monocrystalline silicon carbide base and that is used for binding and the surface that is of the monocrystalline silicon carbide wafer and that is used for binding. The dry processing may be plasma bombardment processing. FIG. 3 is a schematic diagram of performing plasma bombardment processing on a surface that is of a monocrystalline silicon carbide base 101 and that is used for binding and a surface that is of a monocrystalline silicon carbide wafer 1021 and that is used for binding.

For example, when plasma bombardment processing is performed on the surface that is of the monocrystalline silicon carbide base and that is used for binding and the surface that is of the monocrystalline silicon carbide and that is used for binding, implanted atoms such as argon (Ar) atoms, neon (Ne), or xenon (Xe) may be used in a vacuum environment, and electrons converted from the implanted atoms may be accelerated by using implantation energy of 0.1 kiloelectronvolt (keV) to 400 keV For example, when Ar atoms are used for bombardment, implantation energy may be 20 keV, and bombardment duration may be one minute.

To improve a processing effect of dry processing or wet processing, before dry processing or wet processing is performed on the surface that is of the monocrystalline silicon carbide base and that is used for binding and the surface that is of the monocrystalline silicon carbide wafer and that is used for binding, the surface that is of the monocrystalline silicon carbide base and that is used for binding and the surface that is of the monocrystalline silicon carbide wafer and that is used for binding may be further cleaned in advance to remove contaminants such as organic compounds, particles, and metal impurities that may exist on the surface that is of the monocrystalline silicon carbide base and that is used for binding and the surface that is of the monocrystalline silicon carbide wafer and that is used for binding. For example, an RCA method (a wet cleaning method) may be used to clean the surface that is of the monocrystalline silicon carbide base and that is used for binding and the surface that is of the monocrystalline silicon carbide wafer and that is used for binding.

Further, after the dry processing or the wet processing, N-type doping may be further performed on one or two of the surface that is of the monocrystalline silicon carbide base and that is used for binding and the surface that is of the monocrystalline silicon carbide wafer and that is used for binding. During N-type doping, a dopant may be nitrogen atoms or phosphorus atoms, a dose may be e¹³ cm⁻² to e¹⁶ cm⁻², and implementation energy of the dopant may be 1 keV to 400 keV After the doping is completed, free electrons are formed in the doped monocrystalline silicon carbide wafer and the doped monocrystalline silicon carbide base, and the free electrons can improve conductive performance of the material, so that the ohmic contact characteristic between the monocrystalline silicon carbide base and the monocrystalline silicon carbide wafer is improved. For example, when N-type doping is performed by using nitrogen atoms, implantation energy may be 30 keV, and a dose may be e¹⁵ cm⁻²,

It should be noted that in the example, not part of the invention, when the material of the base is graphite, surface pretreatment may also be performed on a surface that is of the graphite base and that is used for binding and the surface that is of the monocrystalline silicon carbide wafer and that is used for binding. For the implementation process of performing surface pretreatment on the graphite substrate, correspondingly refer to the implementation process of step 202. In addition, N-type doping is performed on the graphite base, so that an ohmic contact characteristic between the graphite base and a 4H-SiC layer can be effectively ensured.

Step 203: Bind, to the surface that is of the monocrystalline silicon carbide base and that is obtained through surface pretreatment, the surface that is of the monocrystalline silicon carbide wafer and that is obtained through surface pretreatment.

After surface pretreatment performed on the surface that is of the monocrystalline silicon carbide base and that is used for binding and the surface that is of the monocrystalline silicon carbide wafer and that is used for binding is completed, as shown in FIG. 4, in a vacuum environment with low pressure and a normal temperature, the surface that is of the monocrystalline silicon carbide wafer and that is used for binding may be press-fitted on the surface that is of the monocrystalline silicon carbide base and that is used for binding, so that atomic bonds at the surface that is of the monocrystalline silicon carbide wafer and that is used for binding and atomic bonds at the surface that is of the monocrystalline silicon carbide base and that is used for binding are bonded under action of a van der Waals force, so that the monocrystalline silicon carbide wafer and the monocrystalline silicon carbide base are bound.

It should be noted that when the semiconductor substrate is produced, it may be determined, based on an application requirement, whether to perform step 202. In addition, when it is determined not to perform step 202, the implementation process of step 203 includes: binding the monocrystalline silicon carbide wafer to the monocrystalline silicon carbide base. In addition, when the base is a graphite base, for an implementation process of binding, to the surface that is of the graphite base and that is obtained through surface pretreatment, the surface that is of the monocrystalline silicon carbide wafer and that is obtained through surface pretreatment, correspondingly refer to the implementation process of step 203.

Step 204: Peel off a monocrystalline silicon carbide layer of a specified thickness from a side that is of the monocrystalline silicon carbide wafer and that is away from the monocrystalline silicon carbide base, to obtain the semiconductor substrate.

The specified thickness is less than the thickness of the monocrystalline silicon carbide wafer. For example, the thickness of the monocrystalline silicon carbide wafer may be 350 microns, and the specified thickness may be 340 microns. In addition, a direction of the thickness is perpendicular to a direction in which the binding surface between the monocrystalline silicon carbide wafer and the monocrystalline silicon carbide base is located. For example, as shown in FIG. 4, the direction in which the binding surface is located is a direction X, the direction of the thickness is a direction Y, and the direction X is perpendicular to the direction Y.

The semiconductor substrate is obtained after the monocrystalline silicon carbide layer of the specified thickness is peeled off. The semiconductor substrate includes the monocrystalline silicon carbide base and a monocrystalline silicon carbide layer stacked on the monocrystalline silicon carbide base. In addition, after the monocrystalline silicon carbide layer of the specified thickness is peeled off, chemical mechanical polishing may be further performed on a surface that is of the monocrystalline silicon carbide layer and that is away from the monocrystalline silicon carbide base, to ensure flatness of the monocrystalline silicon carbide layer, so that an epitaxial layer, a semiconductor film layer, and the like can be formed on the surface of the monocrystalline silicon carbide layer. Further, chemical mechanical polishing may be performed on a peeling surface of the monocrystalline silicon carbide layer that is peeled off, so that the monocrystalline silicon carbide layer that is peeled off can be repeatedly used.

Optionally, the peeling operation may be implemented in a plurality of manners. In a feasible manner, a separation layer (as shown by a dashed line in FIG. 3 or FIG. 4) may be formed in the monocrystalline silicon carbide wafer 1021 in advance. When the peeling operation is performed, the monocrystalline silicon carbide wafer 1021 may be layered at the separation layer, and then the monocrystalline silicon carbide layer of the specified thickness (a part above the dashed line in FIG. 4) is peeled off from the separation layer, to obtain the semiconductor substrate shown in FIG. 1.

As shown in FIG. 5, an implementation of forming the separation layer may include: performing ion implantation processing on the monocrystalline silicon carbide wafer 1021 from a side, of the monocrystalline silicon carbide wafer, away from the surface that is of the monocrystalline silicon carbide wafer and that is used for binding, to form an ion implantation layer in the monocrystalline silicon carbide wafer 1021. Correspondingly, when the peeling operation is performed, layering processing may be performed on the monocrystalline silicon carbide wafer 1021 in which the ion implantation layer is formed, so that the monocrystalline silicon carbide wafer is layered at the ion implantation layer, and a peeling operation is performed on the layered monocrystalline silicon carbide wafer from the ion implantation layer to obtain the semiconductor substrate.

For example, hydrogen (H) atoms or helium (He) atoms may be implanted into the monocrystalline silicon carbide wafer from the side, of the monocrystalline silicon carbide wafer, away from the surface that is of the monocrystalline silicon carbide wafer and that is used for binding, an implantation dose ranges from e¹⁵ cm⁻² to e¹⁸ cm⁻², and implantation energy is 1 keV to 400 keV, so that the ion implantation layer is formed in the monocrystalline silicon carbide wafer. Correspondingly, high-temperature annealing processing may be performed on the monocrystalline silicon carbide wafer in which the ion implantation layer is formed, so that the monocrystalline silicon carbide wafer is layered at the ion implantation layer. In addition, the high-temperature annealing processing can eliminate a lattice defect in the semiconductor substrate, so that performance of the semiconductor substrate can be improved.

For example, a processing environment of the high-temperature annealing processing may be an argon atmosphere, an annealing temperature may be 1000 degrees Celsius (°C), and annealing time may be 10 minutes. For another example, when the ion implantation layer is formed in the monocrystalline silicon carbide wafer, implanted atoms may be H atoms, an implantation dose may be e¹⁷ cm⁻², and implantation energy may be 150 keV Correspondingly, high-temperature annealing processing may be performed in an argon atmosphere, an annealing temperature may be 1100°C, and annealing time may be 60 minutes. For another example, when the ion implantation layer is formed in the monocrystalline silicon carbide wafer, implanted atoms may be He atoms, an implantation dose may be e¹⁷ cm⁻², and implantation energy may be 300 keV Correspondingly, high-temperature annealing processing may be performed in an argon atmosphere, an annealing temperature may be 1700°C, and annealing time may be 30 minutes.

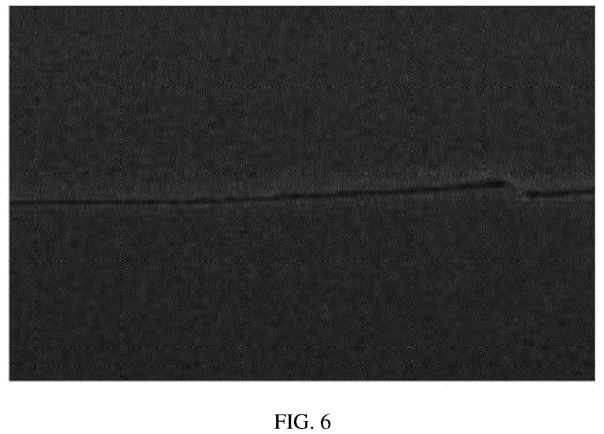

For example, as shown in FIG. 6, after high-temperature annealing processing is performed on the monocrystalline silicon carbide wafer in which the ion implantation layer is formed, the monocrystalline silicon carbide wafer is clearly layered at the ion implantation layer, and in this case, a peeling operation may be performed on the monocrystalline silicon carbide wafer from the ion implantation layer to obtain the semiconductor substrate.

It should be noted that the operation of forming the separation layer in the monocrystalline silicon carbide base may be performed after the process of binding the monocrystalline silicon carbide wafer and the monocrystalline silicon carbide base is completed and before the peeling operation is performed, or may be performed before the binding process, or even the monocrystalline silicon carbide base provided in step 201 may be a monocrystalline silicon carbide base in which the separation layer has been formed. This is not specifically limited in this embodiment of this application. In a feasible manner, the operation of forming the separation layer in the monocrystalline silicon carbide base may be performed before step 202.

It should be further noted that in the example not part of the present invention, when the base is a graphite base, for an implementation process of peeling off the monocrystalline silicon carbide layer of the specified thickness from a side that is of the monocrystalline silicon carbide wafer and that is away from the graphite base, correspondingly refer to the implementation process of step 204.

In conclusion, in the production method for the semiconductor substrate provided in this embodiment of this application, because the materials of both the monocrystalline silicon carbide base and the monocrystalline silicon carbide layer that are used by the semiconductor substrate are monocrystalline silicon carbide, a material difference between the monocrystalline silicon carbide base and the monocrystalline silicon carbide layer is reduced, and a probability that a heterojunction occurs on the binding surface is reduced. Therefore, while controlling costs of the semiconductor substrate to be relatively low, using the monocrystalline silicon carbide base with a relatively low quality indicator can ensure the ohmic contact characteristic between the monocrystalline silicon carbide base and the monocrystalline silicon carbide layer without a need to perform additional processing on the binding surface in the production process, to simplify the production process of the semiconductor substrate.

In addition, because the material of the base in the semiconductor substrate is monocrystalline silicon carbide, in comparison with a related technology in which a produced 4H-SiC epitaxial layer needs to be sufficiently thick because a semiconductor substrate does not include a base, in the semiconductor substrate, thicknesses of the monocrystalline silicon carbide layer and the 4H-SiC epitaxial layer can be determined based on a voltage level of the semiconductor device. Therefore, the semiconductor substrate can be applied to producing semiconductor devices of all voltage levels, so that an application scope of the semiconductor substrate is expanded.

It should be noted that a sequence of the steps of the production method for the semiconductor substrate may be appropriately adjusted, or the steps may be increased or decreased accordingly based on a situation. For example, in the production process of the semiconductor substrate, it may be determined, based on an application requirement, whether to perform step 202. Any variation method readily figured out by a person skilled in the art within the technical scope disclosed in this application shall fall within the protection scope of this application. Therefore, details are not described herein.

An embodiment of this application further provides a semiconductor device. The semiconductor device includes the semiconductor substrate provided in embodiment of this application and at least one semiconductor film layer disposed on the semiconductor substrate.

Optionally, the semiconductor device may be a power device such as a switch device or a rectifier device. For example, the semiconductor device may be a metal-oxide-semiconductor field-effect transistor (metal oxide semiconductor field effect transistor, MOSFET) or a Schottky barrier diode (Schottky barrier diode, SBD).

The term "and/or" in this application describes only an association relationship for describing associated objects and indicates that three relationships may exist. For example, A and/or B may indicate the following three cases: Only A exists, both A and B exist, and only B exists. In addition, the character "/" in this specification usually indicates an "or" relationship between the associated objects.

## Claims

1. A semiconductor substrate (10), wherein the semiconductor substrate (10) comprises:
a monocrystalline silicon carbide base (101); and
a monocrystalline silicon carbide layer (102) stacked on a side of the monocrystalline silicon carbide base (101), wherein
a quality indicator of the monocrystalline silicon carbide base (101) is lower than a quality indicator of the monocrystalline silicon carbide layer,
wherein N-type doping is performed on a surface that is of the monocrystalline silicon carbide base and that is used for binding and a surface that is of the monocrystalline silicon carbide layer and that is used for binding, so that free electrons are formed in the doped monocrystalline silicon carbide layer and the doped monocrystalline silicon carbide base.

2. The semiconductor substrate (10) according to claim 1, wherein a crystal structure of the monocrystalline silicon carbide base (101) is the same as that of the monocrystalline silicon carbide layer (102).

3. The semiconductor substrate (10) according to claim 2, wherein both a material of the monocrystalline silicon carbide base (101) and a material of the monocrystalline silicon carbide layer (102) are hexagonal silicon carbide whose stacking periodicity is 4.

4. The semiconductor substrate (10) according to any one of claims 1 to 3, wherein the quality indicator is reflected by one or more of the following: micropipe density, dislocation fault density, stacking fault density, a proportion of polytype areas, and a proportion of carbon inclusions areas.

5. A production method for a semiconductor substrate, wherein the method comprises:
providing (201) a monocrystalline silicon carbide base (101) and a monocrystalline silicon carbide wafer (1021), wherein a quality indicator of the monocrystalline silicon carbide base (101) is lower than a quality indicator of the monocrystalline silicon carbide wafer (1021);
performing N-type doping on a surface that is of the monocrystalline silicon carbide base and that is used for binding and a surface that is of the monocrystalline silicon carbide wafer and that is used for binding, so that free electrons are formed in the doped monocrystalline silicon carbide wafer and the doped monocrystalline silicon carbide base;
binding (203) the monocrystalline silicon carbide wafer (1021) to the monocrystalline silicon carbide base (101); and
peeling off (204) a monocrystalline silicon carbide layer of a specified thickness from a side that is of the monocrystalline silicon carbide wafer (1021) and that is away from the monocrystalline silicon carbide base (101), to obtain the semiconductor substrate, wherein the specified thickness is less than a thickness of the monocrystalline silicon carbide wafer (1021), and a direction of the thickness is perpendicular to a direction in which a binding surface between the monocrystalline silicon carbide wafer (1021) and the monocrystalline silicon carbide base (101) is located.

6. The method according to claim 5, wherein before the binding (203) the monocrystalline silicon carbide wafer to the monocrystalline silicon carbide base, the method further comprises:
separately performing (202) surface pretreatment on the surface that is of the monocrystalline silicon carbide base (101) and that is used for binding and the surface that is of the monocrystalline silicon carbide wafer (1021) and that is used for binding, to improve an ohmic contact characteristic between the monocrystalline silicon carbide base and the monocrystalline silicon carbide wafer that are bound; and
the binding the monocrystalline silicon carbide wafer to the monocrystalline silicon carbide base comprises:
binding (203), to the surface that is of the monocrystalline silicon carbide base (101) and that is obtained through surface pretreatment, the surface that is of the monocrystalline silicon carbide wafer (1021) and that is obtained through surface pretreatment.

7. The method according to claim 6, wherein the separately performing (202) surface pretreatment on the surface that is of the monocrystalline silicon carbide base and that is used for binding and the surface that is of the monocrystalline silicon carbide wafer and that is used for binding comprises:
separately performing plasma bombardment processing on the surface that is of the monocrystalline silicon carbide base and that is used for binding and the surface that is of the monocrystalline silicon carbide wafer and that is used for binding.

8. The method according to claim 7, wherein after the separately performing plasma bombardment processing on the surface that is of the monocrystalline silicon carbide base and that is used for binding and the surface that is of the monocrystalline silicon carbide wafer and that is used for binding, the separately performing surface pretreatment on the surface that is of the monocrystalline silicon carbide base and that is used for binding and the surface that is of the monocrystalline silicon carbide wafer and that is used for binding further comprises:
performing N-type doping on one or two of the surface that is of the monocrystalline silicon carbide base and that is used for binding and the surface that is of the monocrystalline silicon carbide wafer and that is used for binding.

9. The method according to any one of claims 5 to 8, wherein before the peeling off (204) a monocrystalline silicon carbide layer of a specified thickness from a side that is of the monocrystalline silicon carbide wafer and that is away from the monocrystalline silicon carbide base, to obtain the semiconductor substrate, the method further comprises:
performing ion implantation processing on the monocrystalline silicon carbide wafer from a side, of the monocrystalline silicon carbide wafer, away from the surface that is of the monocrystalline silicon carbide wafer and that is used for binding, to form an ion implantation layer in the monocrystalline silicon carbide wafer; and
the peeling off (204) a monocrystalline silicon carbide layer of a specified thickness from a side that is of the monocrystalline silicon carbide wafer and that is away from the monocrystalline silicon carbide base, to obtain the semiconductor substrate comprises:
performing layering processing on the monocrystalline silicon carbide wafer in which the ion implantation layer is formed, so that the monocrystalline silicon carbide wafer is layered at the ion implantation layer; and
performing a peeling operation on the layered monocrystalline silicon carbide wafer from the ion implantation layer to obtain the semiconductor substrate.

10. A semiconductor device, comprising the semiconductor substrate (10) according to any one of claims 1 to 4 and at least one semiconductor film layer disposed on the semiconductor substrate.

## Patentansprüche

1. Halbleitersubstrat (10), wobei das Halbleitersubstrat (10) umfasst:
eine monokristalline Siliciumcarbidbasis (101); und
eine monokristalline Siliciumcarbidschicht (102), die auf einer Seite der monokristallinen Siliciumcarbidbasis (101) gestapelt ist,
wobei
ein Qualitätsindikator der monokristallinen Siliciumcarbidbasis (101) niedriger ist als ein Qualitätsindikator der monokristallinen Siliciumcarbidschicht,
wobei eine N-Dotierung auf einer Oberfläche der monokristallinen Siliciumcarbidbasis, die zur Bindung verwendet wird, und einer Oberfläche der monokristallinen Siliciumcarbidschicht, die zur Bindung verwendet wird, durchgeführt wird, sodass in der dotierten monokristallinen Siliciumcarbidschicht und der dotierten monokristallinen Siliciumcarbidbasis freie Elektronen ausgebildet werden.

2. Halbleitersubstrat (10) nach Anspruch 1, wobei eine Kristallstruktur der monokristallinen Siliciumcarbidbasis (101) die gleiche ist wie die der monokristallinen Siliciumcarbidschicht (102).

3. Halbleitersubstrat (10) nach Anspruch 2, wobei sowohl ein Material der monokristallinen Siliciumcarbidbasis (101) als auch ein Material der monokristallinen Siliciumcarbidschicht (102) hexagonales Siliciumcarbid ist, dessen Stapelperiodizität 4 beträgt.

4. Halbleitersubstrat (10) nach einem der Ansprüche 1 bis 3, wobei der Qualitätsindikator durch eines oder mehrere der folgenden Elemente widergespiegelt wird: Mikropipe-Dichte, Versetzungsfehlerdichte, Stapelfehlerdichte, einen Anteil von Polytypenbereichen und einen Anteil von Kohlenstoffeinschlussgebieten.

5. Herstellungsverfahren für ein Halbleitersubstrat, wobei das Verfahren umfasst:
Bereitstellen (201) einer monokristallinen Siliciumcarbidbasis (101) und eines monokristallinen Siliciumcarbidwafers (1021), wobei ein Qualitätsindikator der monokristallinen Siliciumcarbidbasis (101) niedriger ist als ein Qualitätsindikator des monokristallinen Siliciumcarbidwafers (1021);
Durchführen einer N-Dotierung auf einer Oberfläche der monokristallinen Siliciumcarbidbasis, die zur Bindung verwendet wird, und einer Oberfläche des monokristallinen Siliciumcarbidwafers, die zur Bindung verwendet wird, sodass in dem dotierten monokristallinen Siliciumcarbidwafer und der dotierten monokristallinen Siliciumcarbidbasis freie Elektronen ausgebildet werden,
Binden (203) des monokristallinen Siliciumcarbidwafers (1021) an die monokristalline Siliciumcarbidbasis (101);
und
Abziehen (204) einer monokristallinen Siliciumcarbidschicht mit einer bestimmten Dicke von einer Seite des monokristallinen Siliciumcarbidwafers (1021), die der monokristallinen Siliciumcarbidbasis (101) abgewandt ist, um das Halbleitersubstrat zu erhalten, wobei die bestimmte Dicke geringer ist als eine Dicke des monokristallinen Siliciumcarbidwafers (1021) und eine Richtung der Dicke senkrecht zu einer Richtung liegt, in der eine Bindungsoberfläche zwischen dem monokristallinen Siliciumcarbidwafer (1021) und der monokristallinen Siliciumcarbidbasis (101) verläuft.

6. Verfahren nach Anspruch 5, wobei vor dem Binden (203) des monokristallinen Siliciumcarbidwafers an die monokristalline Siliciumcarbidbasis das Verfahren ferner umfasst:
getrenntes Durchführen (202) einer Oberflächenvorbehandlung auf der Oberfläche der monokristallinen Siliciumcarbidbasis (101), die zur Bindung verwendet wird, und der Oberfläche des monokristallinen Siliciumcarbidwafers (1021), die zur Bindung verwendet wird, um eine ohmsche Kontaktcharakteristik zwischen der monokristallinen Siliciumcarbidbasis und dem monokristallinen Siliciumcarbidwafer, die aneinander gebunden sind, zu verbessern; und
das Binden des monokristallinen Siliciumcarbidwafers an die monokristalline Siliciumcarbidbasis umfasst:
Binden (203), an die Oberfläche der monokristallinen Siliciumcarbidbasis (101), die durch Oberflächenvorbehandlung erhalten wird, der Oberfläche des monokristallinen Siliciumcarbidwafers (1021), die durch Oberflächenvorbehandlung erhalten wird.

7. Verfahren nach Anspruch 6, wobei das getrennte Durchführen (202) einer Oberflächenvorbehandlung auf der Oberfläche der monokristallinen Siliciumcarbidbasis, die zur Bindung verwendet wird, und der Oberfläche des monokristallinen Siliciumcarbidwafers, die zur Bindung verwendet wird, umfasst:
getrenntes Durchführen einer Plasmabombardierungsverarbeitung auf der Oberfläche der monokristallinen Siliciumcarbidbasis, die zur Bindung verwendet wird, und der Oberfläche des monokristallinen Siliciumcarbidwafers, die zur Bindung verwendet wird.

8. Verfahren nach Anspruch 7, wobei nach dem getrennten Durchführen einer Plasmabombardierungsverarbeitung auf der Oberfläche der monokristallinen Siliciumcarbidbasis, die zur Bindung verwendet wird, und der Oberfläche des monokristallinen Siliciumcarbidwafers, die zur Bindung verwendet wird, das getrennte Durchführen der Oberflächenvorbehandlung auf der Oberfläche der monokristallinen Siliciumcarbidbasis, die zur Bindung verwendet wird, und der Oberfläche des monokristallinen Siliciumcarbidwafers, die zur Bindung verwendet wird, ferner umfasst:
Durchführen von N-Dotierung auf einer oder auf zwei der Oberfläche der monokristallinen Siliciumcarbidbasis, die zur Bindung verwendet wird, und der Oberfläche des monokristallinen Siliciumcarbidwafers, die zur Bindung verwendet wird.

9. Verfahren nach einem der Ansprüche 5 bis 8, wobei vor dem Abziehen (204) einer monokristallinen Siliciumcarbidschicht mit einer bestimmten Dicke von einer Seite des monokristallinen Siliciumcarbidwafers, die der monokristallinen Siliciumcarbidbasis abgewandt ist, um das Halbleitersubstrat zu erhalten, das Verfahren ferner umfasst:
Durchführen einer Ionenimplantationsverarbeitung auf dem monokristallinen Siliciumcarbidwafer von einer Seite des monokristallinen Siliciumcarbidwafers, die der Oberfläche des monokristallinen Siliciumcarbidwafers abgewandt ist und zum Binden verwendet wird, um eine Ionenimplantationsschicht im monokristallinen Siliciumcarbidwafer auszubilden; und
das Abziehen (204) einer monokristallinen Siliciumcarbidschicht mit einer bestimmten Dicke von einer Seite des monokristallinen Siliciumcarbidwafers, die der monokristallinen Siliciumcarbidbasis abgewandt ist, um das Halbleitersubstrat zu erhalten, umfasst:
Durchführen einer Schichtverarbeitung auf dem monokristallinen Siliciumcarbidwafer, in dem die Ionenimplantationsschicht ausgebildet wird, sodass der monokristalline Siliciumcarbidwafer an der Ionenimplantationsschicht geschichtet wird, und
Durchführen eines Abziehvorgangs an dem geschichteten monokristallinen Siliciumcarbidwafer von der Ionenimplantationsschicht, um das Halbleitersubstrat zu erhalten.

10. Halbleitervorrichtung, umfassend das Halbleitersubstrat (10) nach einem der Ansprüche 1 bis 4 und mindestens eine auf dem Halbleitersubstrat angeordnete Halbleiterfilmschicht.

## Revendications

1. Substrat semi-conducteur (10), le substrat semi-conducteur (10) comprenant :
une base de carbure de silicium monocristallin (101) ; et
une couche de carbure de silicium monocristallin (102) empilée sur un côté de la base de carbure de silicium monocristallin (101),
un indicateur de qualité de la base de carbure de silicium monocristallin (101) étant inférieur à un indicateur de qualité de la couche de carbure de silicium monocristallin, un dopage de type N étant réalisé sur une surface qui est de la base de carbure de silicium monocristallin et qui est utilisée pour une liaison et une surface qui est de la couche de carbure de silicium monocristallin et qui est utilisée pour une liaison, de sorte que des électrons libres sont formés dans la couche de carbure de silicium monocristallin dopée et la base de carbure de silicium monocristallin dopée.

2. Substrat semi-conducteur (10) selon la revendication 1, une structure cristalline de la base de carbure de silicium monocristallin (101) étant la même que celle de la couche de carbure de silicium monocristallin (102).

3. Substrat semi-conducteur (10) selon la revendication 2, à la fois un matériau de la base de carbure de silicium monocristallin (101) et un matériau de la couche de carbure de silicium monocristallin (102) étant du carbure de silicium hexagonal dont la périodicité d'empilement est 4.

4. Substrat semi-conducteur (10) selon l'une quelconque des revendications 1 à 3, l'indicateur de qualité étant reflété par l'un ou plusieurs des éléments suivants : densité de microtube, densité de défauts de dislocation, densité de défauts d'empilement, une proportion de zones polytype et une proportion de zones d'inclusions de carbone.

5. Procédé de production pour un substrat semi-conducteur, le procédé comprenant :
la fourniture (201) d'une base de carbure de silicium monocristallin (101) et d'une plaquette de carbure de silicium monocristallin (1021), un indicateur de qualité de la base de carbure de silicium monocristallin (101) étant inférieur à un indicateur de qualité de la plaquette de carbure de silicium monocristallin (1021) ;
la réalisation d'un dopage de type N sur une surface qui est de la base de carbure de silicium monocristallin et qui est utilisée pour une liaison et une surface qui est de la plaquette de carbure de silicium monocristallin et qui est utilisée pour une liaison, de sorte que des électrons libres sont formés dans la plaquette de carbure de silicium monocristallin dopée et la base de carbure de silicium monocristallin dopée ;
la liaison (203) de la plaquette de carbure de silicium monocristallin (1021) à la base de carbure de silicium monocristallin (101) ; et
le pelage (204) d'une couche de carbure de silicium monocristallin d'une épaisseur spécifiée d'un côté qui est de la plaquette de carbure de silicium monocristallin (1021) et qui est à l'écart de la base de carbure de silicium monocristallin (101), pour obtenir le substrat semi-conducteur, l'épaisseur spécifiée étant inférieure à une épaisseur de la plaquette de carbure de silicium monocristallin (1021), et une direction de l'épaisseur étant perpendiculaire à une direction dans laquelle une surface de liaison entre la plaquette de carbure de silicium monocristallin (1021) et la base de carbure de silicium monocristallin (101) est située.

6. Procédé selon la revendication 5, avant la liaison (203) de la plaquette de carbure de silicium monocristallin à la base de carbure de silicium monocristallin, le procédé comprenant en outre :
de manière séparée la réalisation (202) d'un prétraitement de surface sur la surface qui est de la base de carbure de silicium monocristallin (101) et qui est utilisée pour une liaison et la surface qui est de la plaquette de carbure de silicium monocristallin (1021) et qui est utilisée pour une liaison, pour améliorer une caractéristique de contact ohmique entre la base de carbure de silicium monocristallin et la plaquette de carbure de silicium monocristallin qui sont liées ; et
la liaison de la plaquette de carbure de silicium monocristallin à la base de carbure de silicium du cristallin comprenant :
la liaison (203), à la surface qui est de la base de carbure de silicium monocristallin (101) et qui est obtenue par le biais d'un prétraitement de surface, de la surface qui est de la plaquette de carbure de silicium monocristallin (1021) et qui est obtenue par le biais d'un prétraitement de surface.

7. Procédé selon la revendication 6, la réalisation de manière séparée (202) d'un prétraitement de surface sur la surface qui est de la base de carbure de silicium monocristallin et qui est utilisée pour une liaison et la surface qui est de la plaquette de carbure de silicium monocristallin et qui est utilisée pour une liaison comprenant :
de manière séparée la réalisation d'un traitement par bombardement de plasma sur la surface qui est de la base de carbure de silicium monocristallin et qui est utilisée pour une liaison et la surface qui est de la plaquette de carbure de silicium monocristallin et qui est utilisée pour une liaison.

8. Procédé selon la revendication 7, après la réalisation de manière séparée d'un traitement par bombardement de plasma sur la surface qui est de la base de carbure de silicium monocristallin et qui est utilisée pour une liaison et la surface qui est de la plaquette de carbure de silicium monocristallin et qui est utilisée pour une liaison, la réalisation de manière séparée d'un prétraitement de surface sur la surface qui est de la base de carbure de silicium monocristallin et qui est utilisée pour une liaison et la surface qui est de la plaquette de carbure de silicium monocristallin et qui est utilisée pour une liaison comprenant en outre :
la réalisation d'un dopage de type N sur une ou deux parmi la surface qui est de la base de carbure de silicium monocristallin et qui est utilisée pour une liaison et la surface qui est de la plaquette de carbure de silicium monocristallin et qui est utilisée pour une liaison.

9. Procédé selon l'une quelconque des revendications 5 à 8, avant le pelage (204) d'une couche de carbure de silicium monocristallin d'une épaisseur spécifiée d'un côté qui est de la plaquette de carbure de silicium monocristallin et qui est à l'écart de la base de carbure de silicium monocristallin, pour obtenir le substrat semi-conducteur, le procédé comprenant en outre :
la réalisation d'un traitement par implantation d'ions sur la plaquette de carbure de silicium monocristallin d'un côté, de la plaquette de carbure de silicium du cristallin, à l'écart de la surface qui est de la plaquette de carbure de silicium monocristallin et qui est utilisée pour une liaison, pour former une couche d'implantation d'ions dans la plaquette de carbure de silicium monocristallin ; et
le pelage (204) d'une couche de carbure de silicium monocristallin d'une épaisseur spécifiée d'un côté qui est de la plaquette de carbure de silicium monocristallin et qui est à l'écart de la base de carbure de silicium monocristallin, pour obtenir le substrat semi-conducteur comprenant :
la réalisation d'un traitement par superposition sur la plaquette de carbure de silicium monocristallin dans laquelle la couche d'implantation d'ions est formée, de sorte que la plaquette de carbure de silicium monocristallin est stratifiée à la couche d'implantation d'ions ; et
la réalisation d'une opération de pelage sur la plaquette de carbure de silicium monocristallin stratifiée de la couche d'implantation d'ions pour obtenir le substrat semi-conducteur.

10. Dispositif semi-conducteur, comprenant le substrat semi-conducteur (10) selon l'une quelconque des revendications 1 à 4 et au moins une couche de film semi-conducteur disposée sur le substrat semi-conducteur.
